Europäisches Patentamt

(19) European Patent Office

Office européen des brevets

(11) Publication number: **0 010 959**
**A1**

(12) **EUROPEAN PATENT APPLICATION**

(21) Application number: 79302387.0

(22) Date of filing: 31.10.79

(51) Int. Cl.³: **H 04 L 7/02**, H 03 L 7/08,
G 11 B 5/09

(30) Priority: 02.11.78 US 957256

(43) Date of publication of application: 14.05.80
Bulletin 80/10

(84) Designated Contracting States: DE FR GB IT

(71) Applicant: SPERRY CORPORATION, 1290 Avenue of
the Americas, New York, N.Y. 10019 (US)

(72) Inventor: Moulton, Robert Kirk, 731A North Wales
Road, North Wales Pa. 19454 (US)
Inventor: Thompson, John Warne, 2944 Banner Road,
Willow Grove Pa. 19090 (US)

(74) Representative: Michaels, Peter Albert, SPERRY
UNIVAC Patent & Licensing Services M.S. S2 W1
SPERRY UNIVAC CENTRE, London NW10 8LS (GB)

(54) **Phase lock loop circuits.**

(57) A phase lock loop (11) is supplied with a pre-
conditioned pulse stream derived in a preconditioning
circuit (10) from coded data pulse sequences not having
transitions in every data cell.

The data pulses are applied to bi-stable devices
(14, 23) of the preconditioning circuit (10), to produce a
delay of one and three halves of a data cell period. The
delayed data pulses, one of which also inverted, are
applied to an exclusive OR gate (28) whose output
connects to a further bistable device (29). The bistable
device (29) provides a signal, having pulse transitions
when the output of the exclusive OR gate is high, to a
second exclusive OR gate (31) which also receives data
delayed by one data cell period and which provides the
preconditioned pulse stream at its output.

An additional exclusive OR gate (33) connected to the
outputs of the bistable devices (14, 23) enables an NRZ
coded signal to be derived from NRZI coded data pulses.

-1-

## Phase Lock Loop Circuits

This invention relates to phase lock loop circuits, and in particular to phase lock loop circuits incorporating preconditioning circuits to convert coded data pulse sequences into a pulse stream which enables the phase lock loop to lock onto the data cell frequency of the coded data.

High density data codes as used, for instance, to store data on magnetic storage media, are generally non-repetitive and may have consecutive data cells in which no transitions occur. Examples of such non-repetitive high density data codes are PM, 3PM, MFM, $M^2FM$ and Cohn-Lempel codes, generically known as M for N rate NRZI codes. In order to recover data coded in such codes from, for example, a disc memory, a clocking signal needs to be provided which is synchronized with the data cell frequency of the coded data. The data cell frequency of data read from a disc memory or other serial data source, is usually subject to fluctuations so that a fixed frequency oscillator will not remain synchronized with the data cell frequency for any appreciable length of time. A phase lock loop, on the other hand, which comprises essentially a variable frequency oscillator controlled by the output of a phase detector, is at least in principle capable of tracking an incoming pulse stream. However, a phase lock loop having a non-harmonic phase detector will not lock onto and remain synchronized with a stream of data pulses which does not have transitions occurring in a predetermined regular pattern. Thus, if a sequence of data pulses coded in the kind of non-repetitive data code described above is applied to a non-harmonic phase detector together with a regular and repetitive clock signal, the output of the phase detector does not correctly represent the relationship between the data cell frequency and the clock signal frequency. The "out-of-synchronization" output of the phase detector consequently results in the loss of synchronization between the output of the variable frequency oscillator and the coded data pulse sequence.

Various solutions have been proposed in the prior art to overcome the problem of synchronizing the output of a phase lock loop with the data cell frequency of data pulse sequences not having a transition in every data cell. Among these is the use of preconditioning circuits and compensating circuits to convert the data pulse sequence into a suitable stream of regular pulses before applying them to the phase lock loop.

Another prior art solution to the problem of driving a phase lock loop with irregular pulses is to employ a logic circuit which senses whether the data pulses are occurring at regular data cell intervals. If the data pulses are regular, they are fed to a nonharmonic phase detector. If the coded data pulses are irregular, the circuit logic switches over to a harmonic phase detector for generating pulses at approximately the data cell frequency.

Other prior art logic circuits have been proposed in which the phase detector of the phase lock loop is initially supplied with a regular series of data pulses at the desired data cell frequency. The voltage level at the input of the phase detector which corresponds to that frequency is measured and duplicated by a matching circuit. Further logic circuitry senses the absence of repetitive data pulses, in which case the matching voltage is substituted at the input of the phase detector to obtain an output which drives the voltage controlled oscillator of the phase lock loop at a desired predetermined frequency.

U.S. patent 3 950 658 shows and teaches a compensation circuit which will generate output clock pulses synchronized with an input data stream of MFM coded data. The circuit employs a charge pump which includes a pair of capacitors. The charge on the two capacitors generates a correction voltage representative of the difference between the data frequency and the clock frequency. The reference also explains that prior art attempts to generate clock pulses from a modified frequency modulation (MFM) raw data signal introduced errors in the voltage controlled oscillator whenever a data pulse was either early or late. In general, delay circuits and logic gating circuits which compare the length of data pulses with clock pulses and/or compare the leading or trailing edges of data pulses with clock pulses generate error signals when the data pulse is distorted or arrives either early or late.

The present invention adopts the first mentioned solution and provides a phase lock loop circuit comprising a phase lock loop and an improved preconditioning circuit to convert a sequence of coded data pulses into a repetitive and regular stream of pulses which enable the phase lock loop to lock on to, and maintain synchronization with, the data cell frequency of the coded data.

The improved preconditioning circuit does not require adaptation of the phase lock loop design, and hence may be used in combination with commercially available (and therefore inexpensive) phase lock loops.

The construction of the improved preconditioning circuit is relatively simple, requiring only a small number of logic gates and bistable devices, and can easily be implemented as a single integrated circuit chip.

Potential to operate at data cell frequencies of up to 100 MHz, and the possibility of obtaining an NRZ coded data pulse stream from an NRZI coded data sequence together with a clocking signal synchronized with both, are further advantages of the present invention.

The present invention shall now be described further by way of example and with reference to the accompanying drawings, of which

Figure 1 is a schematic block diagram of a phase lock loop circuit according to the present invention.

Figure 2 shows a block diagram of the preconditioning circuit of Figure 1;

Figure 3 shows pulses and waveforms occurring in the circuit of Figure 2;

Figure 4 shows a truth table for a D-type flip-flop;

Figure 5 shows a truth table for an exclusive OR gate; and

Figure 6 shows a truth table for a J-K type flip-flop.

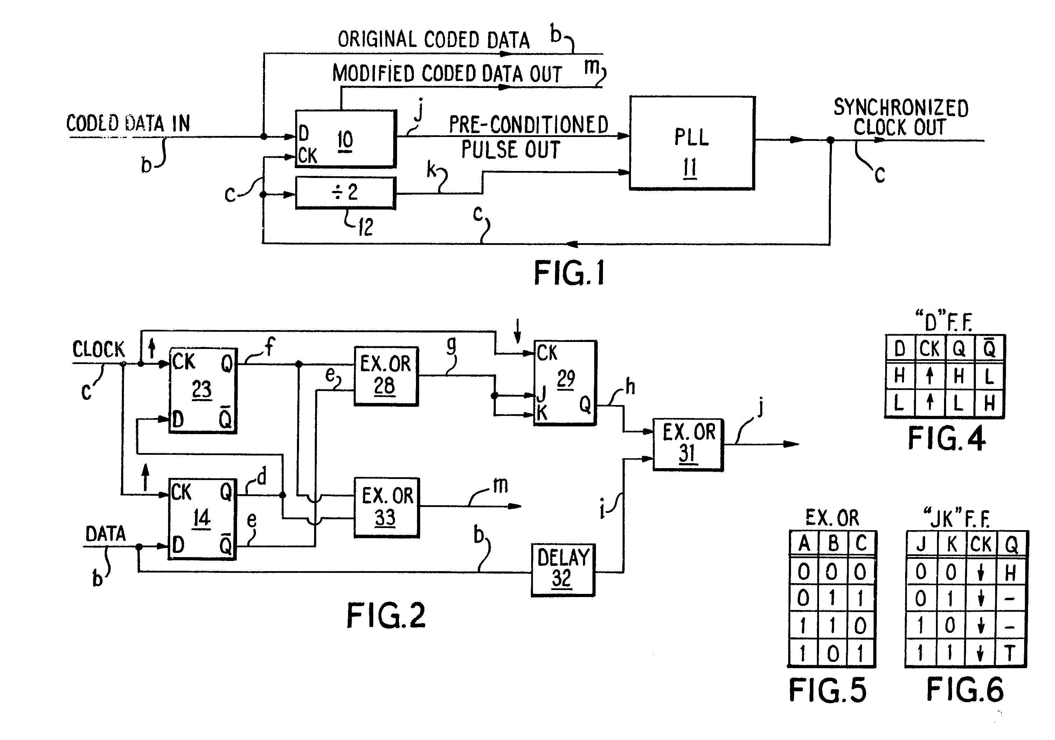

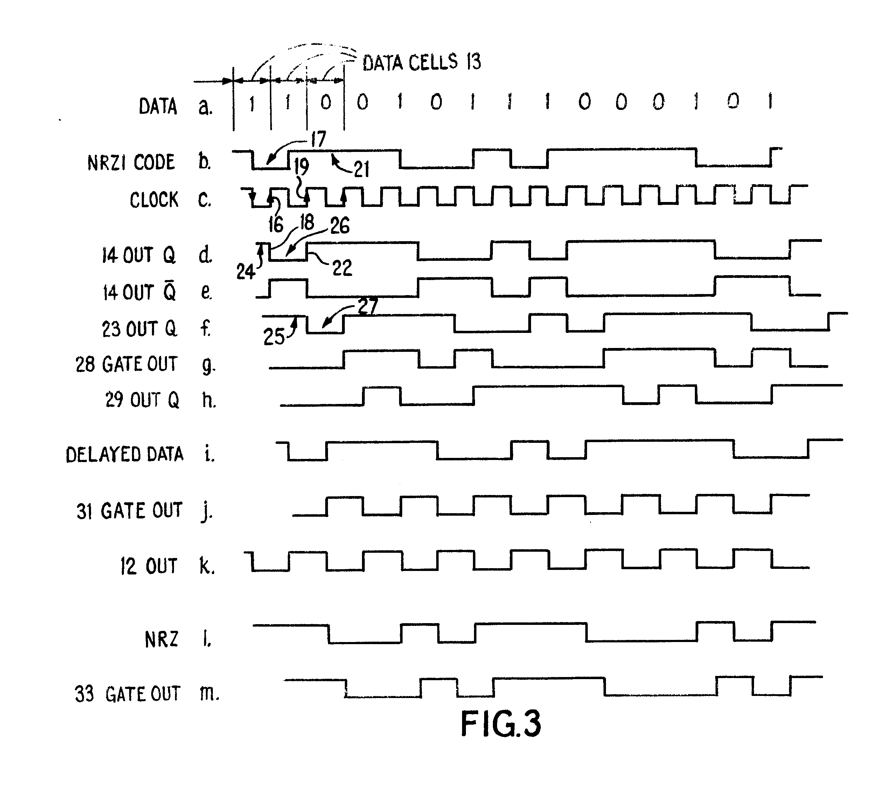

Referring now to Figure 1, a phase lock loop circuit comprises a phase lock loop 11, a preconditioning circuit 10, and a frequency divider 12. A sequence of coded data pulses is applied on line b to the input D of the preconditioning circuit 10, and a stream of clock pulses to the input CK via line c. The output of the preconditioning circuit 10 is applied to an input of a commercially available nonharmonic phase lock loop 11, another input of which is supplied from the frequency divider 12 through line k with every other pulse provided by the synchronized clock pulse output on line c. The divide by two logic 12 may be any commercially available device such as a bi-stable device.

Figures 2 and 3 show the preconditioning circuit 10 of Figure 1, and the associated pulse and waveforms. For purposes of this explanation the stream of coded data pulses at the input is assumed to be 110010111000101 as shown in Figure 3a, the binary data digits being at the centre of the data cells 13. The data stream of Figure 3a is shown as a NRZI coded pulse stream in Figure 3b. Positive or negative transitions occur always at the centre of a data cell, but only if the data cell contains a binary digit 1. Accordingly, a space or pulse three data cells wide occurs as the result of the first two consecutive 0's. Similarly a subsequent pulse two data cells wide is due to the occurrence of data 0, and three consecutive 0's result in a data pulse four data cells wide. High density codes classified as Cohn-Lempel codes, generically known as M for N rate NRZI run bounded codes are non-repetitive and normally have consecutive data cell times in which no transition occurs. In the case of the NRZI code shown in Figure 3b no transitions occur in data cells containing 0 data bits.

Disc file memories which use high density codes to achieve the maximum concentration of data in the smallest possible area, require a train of clock pulses synchronized with the data being read from the memory disc in order to make the data comprehensible. It is impractical to attempt to place a train of clock pulses on the memory disc as was done in the prior art with drum memory systems employing low density data codes. It is desirable that the coded data read from the memory disc either generate the train of clock pulses or synchronize an oscillator which generates the clock pulses.

A train of clock pulses of the type desired for synchronizing the coded data in waveform of Figure 3b is shown in the waveform of Figure 3c. The complete clock cycle provides a positive going transition shown by the arrow pointing up, and a negative transition shown by the arrow pointing down in the waveform of Figure 3c.

The NRZI coded data of the waveform of Figure 3b are applied on line b to the D input of flip-flop 14. The clock input Figure 3c is applied to the clock input CK of flip-flop 14 via line c. The arrow at the clock input CK indicates that the Q output of the D-type flip-flop will assume the state of the data at the D input when the positive edge of the clock arrives at the clock input. The Q output will hold the state so assumed until the D input or a reset input changes the state of the flip-flop 14. The truth table Figure 4 shows the output Q to be high when the clock pulse arrives with the data high. The $\bar{Q}$ output is always exactly opposite to the Q output. Figures 3d and 3e show respectively the outputs at Q and $\bar{Q}$ on lines d and e of Figure 2. The positive transition 16 in Figure 3c generates, due to the presence of negative pulse 17 at the data input of flip-flop 14, the negative transition 18 at the output Q of flip-flop 14 on line d. Similarly the positive clock transition 19 generates transition 22 at the Q output of flip-flop 14 on line d on account of positive pulse 21 at its D input. The waveform in Figure 3d is identical to that of Figure 3b but has been delayed one-half of one cell time. Figure 3e is an inverted image waveform of Figure 3d.

The Q output of flip-flop 14 on line d, shown in Figure 3d, is connected to the data input D of flip-flop 23 and the clock pulses of Figure 3c are connected to the clock input CK of flip-flop 23. The arrow at the clock input CK indicates that the positive transitions of the clock pulses cause the Q output to assume the state of the data "D" input. The first positive transition 16 of the clock pulses in Figure 3, senses the presence of positive pulse 24 on line d and generates the positive pulse 25 shown in Figure 3f. When the next positive clock transition 19 arrives, the negative pulse 26 is present on line d at the data input D of flip-flop 23, and the negative pulse 27 on line f is generated at the Q output of flip-flop 23. Comparing Figures 3d and 3f, it will be seen that the waveform of Figure 3f is delayed by one data cell time compared to the identical waveform of Figure 3d from which it was derived.

The waveform Figures 3e and 3f are applied to the input of exclusive OR gate 28 to generate the output waveform Figure 3g. The truth table for the exclusive OR gate 28 is shown in Figure 5. The output C of an exclusive OR gate is high when and only when one of the A or B inputs is high. The output waveform of exclusive OR gate 28 is applied via line g to the J and K inputs of the J-K flip-flop 29. Clock pulses on line c are applied to the clock input CK of flip-flop 29 and the arrow indicates that the negative transition of the clock pulses strobe the data input lines J and K to determine the next state of the flip-flop.

A truth table for a J-K flip-flop is shown in Figure 6. When both the J and K inputs are 0 the state of the flip-flop remains unchanged or holds condition H. When the J and K inputs are both 1 at the time the negative transition of the clock pulse arrives, the flip-flop toggles (T), that is it changes state. Since the J and K inputs are tied together, they must always be 00 or 11. The Q output of the J-K flip-flop 29 is shown in Figure 3h, and is applied to the input of exclusive OR gate 31 along with the sequence of coded data pulses shown in Figure 3b, which have passed through delay 32 to provide at the other input the delayed NRZI data pulses shown in Figure 3i. The delay 32 may be a fixed delay line since its only purpose is to create a phase shift of one data cell time. If the preconditioning circuit is to be placed on a single integrated circuit chip, an edge triggered flip-flop of the type employed for flip-flops 14 and 23 may be substituted for it. Alternatively, an LRC network may be used in place of the delay 32 in order to achieve the proper data cell delays.

The input waveforms Figure 3h and 3i applied to exclusive OR gate 31 produce the gated output of Figure 3j which is a pulse train having a transition at the centre of each data cell. The output waveform Figure 3j

consists of pre-conditioned pulses which are applied to the phase lock loop 11 (Figure 1) to produce the clock pulses of Figure 3c. Since the clock pulses of Figure 3c have twice as many transitions as the pulse stream of Figure 3j, the frequency of the clock pulses 3c is halved in the divider 12 to produce the waveforms shown in Figure 3k. The waveforms of Figures 3j and 3k are capable of driving a nonharmonic phase detector and of producing an output which will cause the variable frequency oscillator (not shown) of the phase lock loop 11 to lock on to the coded data input sequence applied to the preconditioning circuit 10 via line b.

Figure 3l shows a pulse train of data coded in NRZ code, representing the data shown in Figure 3a. The NRZ code shown in Figure 3l may be produced by applying waveforms Figure 3d and 3e to an exclusive OR gate 33 to produce the NRZ coded data out as shown in Figure 3m. It will be noted that the NRZ coded data out of exclusive OR gate 33 on line m are delayed by one-half of one cell time compared to the waveform of Figure 3l.

From the above explanation with reference to a coded stream of NRZI data pulses having no transitions in one to four or more data cells, it will be understood that other M for N rate NRZI run bounded codes are similarly converted or preconditioned to produce a regular pulse train, such as that shown in Figure 3j, which can be applied to a nonharmonic phase detector to produce clock pulses which are locked on to the data cell frequency of the irregular data.

The phase lock loop 11 shown in the Figures is commercially available as a Signetics 562b chip or may be made up from a 4044 Motorola phase detector and 74S124 TI voltage controlled oscillator. Preferably the J-K flip-flops are 74S112 and the D flip-flops are 74S74 dual edge triggered type flip-flops. The exclusive ORs may be two input quad exclusive ORs designated as 74S86 types.

The same mode of operation as above may be implemented by employing other bi-stable devices fulfilling the same basic functions. For example flip-flops 14, 23 and 29 need not be edge triggered flip-flops, or

-8-

triggered by the positive edge of the clock transition. Bi-stable devices which delay the data pulses applied to their inputs are preferred because their outputs assume the desired state almost instantaneously after being strobed by a clock pulse. The same result as above may also be obtained when the D-type flip-flops 14, 23 are triggered by negative clock transitions, provided the J-K type flip-flop 29 is triggered by positive clock transitions.

-1-

CLAIMS

1.    A phase lock loop circuit including a phase lock loop (11), having a phase detector and a variable frequency oscillator, and a preconditioning circuit (10), characterised in that the preconditioning circuit (10) comprises first and second bistable devices (14, 23) supplying, in response to clocking signals having two clock cycles per data cell period, inverted data pulses delayed by one clock cycle and data pulses delayed by three clock cycles respectively, to first exclusive OR gating means (28), and further comprises second exclusive OR gating means (31) which receive as inputs data pulses, delayed in delay means (32) by two clock cycles, and output pulses of a third bi-stable device (29) producing output pulse transitions in response to the clocking signals when the output of the first exclusive OR gating means (28) is high.

2.    A circuit according to claim 1, characterised in that the clocking signals are supplied by the variable frequency oscillator, and the phase detector receives the output signals of the second exclusive OR gating means (31) together with a signal derived by halving the frequency of the clocking signal in a frequency divider (12).

3.    A circuit according to any preceding claim, characterised in that the first and second bistable devices (14, 23) and/or the delay means (32) are D-type flip-flops.

4.    A circuit according to any preceding claim, characterised in that the third bi-stable device (29) is a JK flip-flop having its J and K inputs connected together.

5.    A circuit according to any preceding claim, characterised in that further exclusive OR gating means (33) receive from the first and second bi-stable devices (14, 23) data pulses delayed by one and three clock cycles thereby to produce at the output of the third exclusive OR gating means (33) an NRZ coded output signal corresponding to, and delayed by two clock cycles in comparison with, an applied sequence of data pulses coded in NRZI coded.

FIG.1

CODED DATA IN — b

SYNCHRONIZED CLOCK OUT — c

PLL 11

ORIGINAL CODED DATA — b
MODIFIED CODED DATA OUT — m
PRE-CONDITIONED PULSE OUT
j
k
c

D 10 CK
÷2 12
c

FIG.2

CLOCK — c
DATA — b

EX.OR 28 — g
EX.OR 33 — m
EX.OR 31 — j

CK 29 Q
J K
h
i

DELAY 32

CK 23 Q Q̄
D
f
CK 14 Q Q̄
D
d
e
e
b

**FIG.4** "D" F.F.

| D | CK | Q | Q̄ |
|---|----|----|----|
| H | ↑ | H | L |
| L | ↑ | L | H |

**FIG.5** EX.OR

| A | B | C |
|---|---|---|
| 0 | 0 | 0 |
| 0 | 1 | 1 |
| 1 | 1 | 0 |
| 1 | 0 | 1 |

**FIG.6** "JK" F.F.

| J | K | CK | Q | Q̄ |
|---|---|----|----|----|
| 0 | 0 | ↑ | Q | Q̄ |
| 0 | 1 | ↑ | L | H |
| 1 | 0 | ↑ | H | L |
| 1 | 1 | ↑ | T | T̄ |

FIG.3

## EUROPEAN SEARCH REPORT

**European Patent Office**

| | DOCUMENTS CONSIDERED TO·BE RELEVANT | | CLASSIFICATION OF THE APPLICATION (Int. Cl.) |
|---|---|---|---|
| Category | Citation of document with indication, where appropriate, of relevant passages | Relevant to claim | |
| | US - A - 3 688 210 (L.W. FORT et al.) <br> * fig. * <br> --- | 1 | H 04 L 7/02 <br> H 03 L 7/08 <br> G 11 B 5/09 |
| P | IBM TECHNICAL DISCLOSURE BULLETIN , <br> Vol. 21, No. 6, November 1978, New York <br> D.L. AHONEN "Bit Synchronizer Using <br> Matched Delays" <br> page 2246 <br> * fig * <br> --- | 2 | |
| P | US - A - 4 156 855 (A.T. CROWLEY) <br> * column 1, line 46 and the following; <br> fig. 1 * <br> --- | 3 | **TECHNICAL FIELDS SEARCHED (Int.Cl.)** |
| | DE - A1 - 2 543 428 (SIEMENS AG) <br> * fig. 1 * <br> --- | 4,5 | G 11 B 5/09 <br> H 03 L 7/00 <br> H 04 L 7/00 |
| A | DE - B2 - 2 703 395 (SPERRY RAND CORP.) <br> * complete document * <br> --- | | |
| A | DE - A1 - 2 648 560 (INT. BUSINESS <br> MACHINES CORP.) <br> * complete document * <br> --- | | **CATEGORY OF CITED DOCUMENTS** <br> X: particularly relevant <br> A: technological background <br> O: non-written disclosure <br> P: intermediate document <br> T: theory or principle underlying the invention <br> E: conflicting application <br> D: document cited in the application <br> L: citation for other reasons |
| A | US - A - 3 628 169 (S.P. CHUR) <br> * complete document * <br> --- | | |
| A | US - A - 3 593 044 (J.H. McNEILLY <br> et al.) <br> * complete document * <br> --- ./.. | | &: member of the same patent family, corresponding document |

X The present search report has been drawn up for all claims

| Place of search | Date of completion of the search | Examiner |
|---|---|---|
| Berlin | 14-01-1980 | BREUSING |

EPO Form 1503.1   06.78

# EUROPEAN SEARCH REPORT

European Patent Office

0010959
Application number

EP 79 302 387.0
- page 2 -

## DOCUMENTS CONSIDERED TO BE RELEVANT

| Category | Citation of document with indication, where appropriate, of relevant passages | Relevant to claim |
|---|---|---|
| A | DE -B - 1 953 484 (INT. BUSINESS MACHINES CORP.)<br>* complete document * | |

CLASSIFICATION OF THE APPLICATION (Int. Cl.)

TECHNICAL FIELDS SEARCHED (Int. Cl.)

EPO Form 1503.2  06.78